Europäisches Patentamt

**European Patent Office**

Office européen des brevets

(19)

(11)  **EP 0 713 113 A1**

(12)  **EUROPÄISCHE PATENTANMELDUNG**

(43) Veröffentlichungstag:
22.05.1996 Patentblatt 1996/21

(51) Int. Cl.$^6$: **G02B 6/42**, G02B 6/43

(21) Anmeldenummer: 95116409.4

(22) Anmeldetag: 18.10.1995

(84) Benannte Vertragsstaaten:
**DE FR GB IT**

(30) Priorität: **17.11.1994 DE 4440935**

(71) Anmelder: **ANT Nachrichtentechnik GmbH**
**D-71522 Backnang (DE)**

(72) Erfinder:
• **Mueller-Fiedler, Roland, Dr. Dipl.-Phys.**
**D-71229 Leonberg (DE)**

• **Mayer, Klaus-Michael, Dr.**
**D-70839 Gerlingen (DE)**
• **Rech, Wolf-Henning, Dr.**
**D-64347 Griesheim (DE)**
• **Hauer, Heiner, Dipl.-Ing.**
**D-70734 Fellbach (DE)**
• **Kuke, Albrecht, Dr. Dr. Ing.**
**D-71549 Auenwald (DE)**
• **Schwander, Thomas, Dipl.-Ing.**
**D-71522 Backnang (DE)**
• **Schwaderer, Bernhard, Dr. Dr. Ing.**
**D-71554 Weissach im Tal (DE)**

(54)  **Optische Sende- und Empfangseinrichtung**

(57)    Bei obigen Einrichtungen ist eine genaue Justierung sehr wichtig; die Einrichtungen sollten jedoch sehr kompakt sein.

Es genügt nicht, die Silizium-Ätztechnik für die Genauigkeit auszunutzen.

Das optische Sendeelement (LD) befindet sich auf einem ersten Träger (T1), das optische Empfangselement (PD) und die Übertragungsfaser (Fa) auf einem dritten Träger.

Dazwischen ist ein zweiter Träger (T2) vorgesehen, der für die Wellenlänge des vom Sendeelement (LD) ausgesendeten Lichts durchlässig ist. Die Träger sind durch anisotropes Ätzen strukturiert, um die Aufnahme der einzelnen Komponenten zu ermöglichen. Außerdem liegen die Träger flach aufeinander und können so justiert werden. Eine Monitordiode (MD) ist vorgesehen.

Anwendung der Anordnung in allen Übertragungssystemen mit Lichtwellenleitern.

Fig. 1

**EP 0 713 113 A1**

## Beschreibung

Die Erfindung betrifft eine optische Sende- und Empfangseinrichtung nach dem Oberbegriff des Patentanspruches 1.

Bei einer optischen Sende- und Empfangseinrichtung muß eine Übertragungsfaser an ein Sendeelement, üblicherweise eine Laserdiode, und an eine Photodiode als Empfangselement angekoppelt werden. In der Übertragungsfaser werden gleichzeitig die Sende- und Empfangssignale in entgegengesetzter Richtung übertragen. Die Sende- und Empfangssignale werden bei gleicher Wellenlänge über einen Strahlteiler und bei unterschiedlichen Wellenlängen über einen wellenlängenselektiven Verzweiger getrennt. Um möglichst geringe Koppelverluste zu erhalten, muß die Faser sowohl an die Laserdiode als auch an die Empfangsdiode optimal angekoppelt werden. Zur Ankopplung eines Lasers an eine Einmodenfaser muß wegen der unterschiedlichen Strahlcharakteristiken von beiden eine Strahltransformation durchgeführt werden. Hierzu wird üblicherweise eine Abbildung mit einer oder zwei Linsen verwendet. Das erforderliche Vergrößerungsverhältnis M liegt entsprechend dem Verhältnis der Modenfelddurchmesser von Laser und Faser bei etwa drei bis fünf. Toleranzen in der Position des Lasers werden durch eine aktive Justage der Faser kompensiert. Der hierzu erforderliche Justagebereich ist in lateraler Richtung, d. h. quer zur Strahlrichtung um den Faktor M größer als der laterale Toleranzbereich des Lasers und in axialer Richtung um den Faktor $M^2$. Die Justage der Faser zum Laser beinflußt auch die Justage der Faser zur Photodiode, so daß insbesondere eine kleinflächige Photodiode, die für höhere Frequenzen geeignet ist, ebenfalls aktiv zur Faser justiert werden muß.

Aus der DE 39 14 835 C1 ist eine Anordnung zur Ankopplung eines Lichtwellenleiters an ein optisches Sende- oder Empfangselement bekannt.

Eine Justierung in der zur optischen Achse lateralen Ebene wird dadurch erreicht, daß Lichtwellenleiter und optisches Sende- oder Empfangselement auf verschiedenen Trägern fixiert sind, die mit ihren Trägeroberflächen verschiebbar aufeinander liegen und daß das Lichtbündel durch zweimalige Spiegelung an je einer auf einem Träger befindlichen Spiegelebene vom Lichtwellenleiter zum optisch aktiven Element oder umgekehrt gelangt. Durch Verschieben der Träger wird eine laterale Justierung durchgeführt. Der Träger, der das Sende- oder Empfangselement trägt, kann aus einem Substrat und einem darauf aufgebrachten Teil bestehen, das eine durchgehende Öffnung aufweist, durch die der Lichtstrahl tritt. Eine Anwendung der Anordnung in allen Übertragungssystemen mit Lichtwellenleitern, in Duplexern mit Lichtein- oder -auskopplung ist möglich. Für den Fall der Ankopplung an ein Sendeelement kann auf dem Träger mit der Faser ein Empfangselement vorgesehen sein.

Ausgehend von diesem Stand der Technik ist es Aufgabe der Erfindung, eine optische Sende- und Empfangseinrichtung anzugeben, bei der der Justageaufwand verringert und die Montage vereinfacht ist.

Die Aufgabe wird durch eine Erfindung mit den Merkmalen der Patentansprüche 1 und 2 gelöst.

Vorteilhafte Weiterbildungen sind in den Unteransprüchen angegeben.

Um den Justageaufwand zu verringern und die Montage zu vereinfachen wird eine optische Sende- und Empfangsvorrichtung vorgeschlagen, bei der nur ein aktiver und automatisierbarer Justageprozeß erforderlich ist, und bei welchem durch präzise und im Großnutzen kostengünstig hergestellte Halterungsstrukturen die Montage der optischen Bauelemente wesentlich vereinfacht wird.

Ausführungsbeispiele der Erfindung werden anhand der Zeichnungen beschrieben. Es zeigen:

Fig. 1 einen Schnitt durch eine erfindungsgemäße Anordnung mit Monitordiode auf dem Träger der Laserdiode;
Fig. 1a einen Schnitt durch eine erfindungsgemäße Anordnung mit Monitordiode auf dem Träger der Übertragungsfaser;
Fig. 2 Aufbau zur Justage der Anordnung;
Fig. 3 erfindungsgemäße Anordnung, wobei der dritte Träger mit seiner Stirnseite zum ersten Träger ausgerichtet ist und
Fig. 4 erfindungsgemäße Anordnung, deren dritter Träger gegenüber der Anordnung nach Fig. 1 vertikal und horizontal gespiegelt ist.

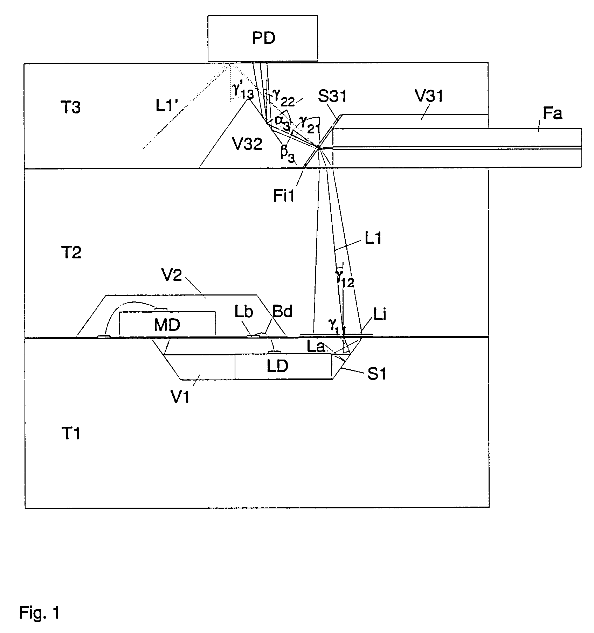

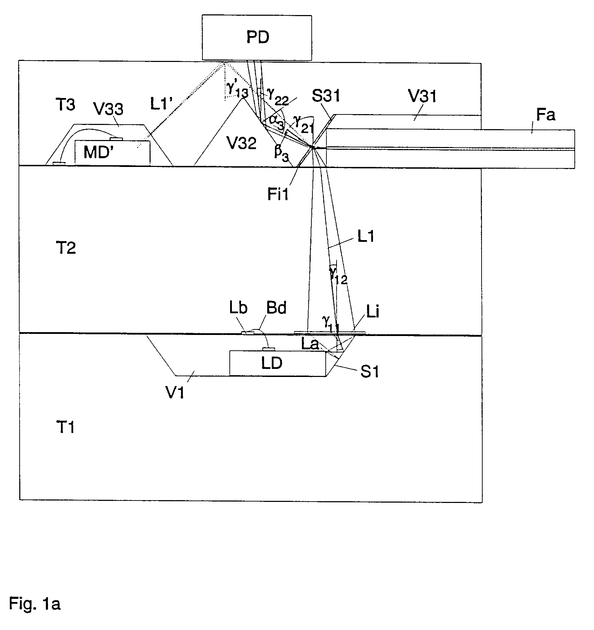

Ein erstes Ausführungbeispiel der erfindungsgemäßen Lösung ist in Fig. 1 dargestellt. In einem ersten Träger T1, der aus einkristallinem Silizium besteht, wird durch anisotropes Ätzen eine Vertiefung V1 erzeugt, die einen ebenen Boden B1 besitzt, auf welchem eine Laserdiode LD montiert ist. Die Seitenflächen der Vertiefung haben infolge des ansiotropen Ätzprozesses einen Neigungswinkel von $\alpha = \arctan(\sqrt{2}) = 54{,}7°$. Zur Erleichterung der Positionierung wird die Laserdiode bei der Montage an die Fußlinien von mindestens zwei rechtwinklig zueinander liegenden Seitenflächen angelegt. Eine dieser Seitenflächen S1 liegt dabei vor der Stirnfläche des Lasers mit der Lichtaustrittsfläche LA. Die Seitenfläche S1 ist verspiegelt, so daß das aus dem Laser austretende Lichtbündel L1 schräg nach oben reflektiert wird. Der zunächst waagerecht austretende Mittenstrahl des Bündels schließt nach der Reflexion an der Seitenwand S1 einen Winkel

$$\gamma_{11} = 2^{*}\alpha - 90° = 19{,}5°$$

mit der Normalen der Oberfläche des Trägers T1 ein. Über dem Träger T1 ist ein zweiter Träger T2 angebracht, der für die Wellenlänge $\lambda_1$ des Laserlichtes transparent ist.

Beispielsweise kann dieser zweite Träger ebenfalls aus Silizium bestehen. Es ist aber auch ein anderes transparentes Material möglich, das mikromechanisch strukturierbar ist wie beispielsweise ein photolitographisch strukturierbares Glas. Auf der Unterseite des Trägers T2 wird in dem Bereich, in dem das Lichtbündel L1 auftrifft eine Linse Li angebracht. Diese Linse kann vorteilhafterweise eine planar aufgebrachte Fresnellinse oder eine holographische Linse sein. Es sind aber auch andere Linsenarten möglich, wie zum Beispiel eine Kugellinse, die in einer mikromechanisch geformten Vertiefung sitzt, oder eine durch Trockenätzen erzeugt Linse. Außerdem ist in der Unterseite des Trägers T2 eine Vertiefung V2 angebracht, damit Platz bleibt für Bonddrähte Bd und Leiterbahnen Lb zur Kontaktierung der Laserdiode LD und für weitere optische oder optoelektronische Bauelemente, die auf der Oberseite des Trägers T1 montiert sind. Hier ist eine Monitordiode MD zur Kontrolle der Laserleistung angebracht.

Die Linse Li wandelt das zunächst divergente Lichtbündel L1 in ein konvergentes Bündel um. Infolge der Lichtbrechung an der Grenzfläche des Trägers T2 wird der Mittelstrahl des Lichtbündels unter dem Winkel

$$\gamma_{12} = \arcsin((n_o/n_2)^*\sin(\gamma_{11}))$$

gebrochen, wobei $n_o$ der Brechungsindex im Raum der Vertiefung V1 und $n_2$ der Brechungsindex im Träger T2 ist.

Ist der Träger T2 aus Silizium mit einem Brechungsindex $n_2 = 3,4777$ und $n_o = 1$ für Luft, so wird $\gamma_{12} = 5,5°$.

Auf der Oberseite des Trägers T2 wird das Lichtbündel wieder in die ursprüngliche Richtung $\gamma_2$ zurückgebrochen. Dort ist ein weiterer Träger T3 angebracht, der wie der Träger T1 ebenfalls aus einkristallinem Silizium besteht. In diesem Träger T3 sind zwei Vertiefungen V31 und V32 anisotrop geätzt. Die Vertiefung V31 ist eine V-Nut zur Aufnahme der Übertragungsfaser Fa. Die Breite dieser V-Nut ist dabei zweckmäßigerweise so groß, daß die unterste Mantellinie der Faser gerade in der Ebene der Unterseite von T3 zu liegen kommt. Die Stirnseite S3 der V-Nut ist mit einem wellenlängenselektiven Filter Fi1 beschichtet. Dieses Filter ist so ausgelegt, daß die Sendewellenlänge $\lambda_1$ reflektiert und die Empfangswellenlänge $\lambda_2$ durchgelassen wird. Das Sendelichtbündel L1 wird an der unter dem Winkel $\alpha$ geneigten Stirnfläche S31 wieder in waagerechte Richtung reflektiert und in die Übertragungsfaser Fa eingekoppelt. Das aus der Übertragungsfaser austretende Empfangslichtbündel L2 mit der Wellenlänge $\lambda_2$ durchdringt das Filter Fi1 und wird an der Grenze zum Silizium unter dem Winkel

$$\gamma_{21} = \alpha + \beta_3,$$

wobei $\beta_3$ der Brechungswinkel an der Stirnfläche S31 mit

$$\beta_3 = \arcsin((n_o/n_3)^*\sin(90°-\alpha))$$

ist, gegen die Flächennormale der Substratoberfläche von T3 in das Silizium hineingebrochen. Dabei ist $n_o$ der Brechungindex in der V-Nut V31 und $n_3 = 3,4777$ der Brechungsindex im Siliziumträger T3. Mit $n_o = 1$ für Luft erhält man $\beta_3 = 9,6°$ und $\gamma_{21} = 64,3°$. Das Lichtbündel L2 trifft auf die Seitenfläche S31 der Vertiefung V31 unter einem Einfallswinkel von

$$\alpha_3 = 180° - 2^*\alpha - \beta_3 = 61,0°.$$

Da dieser Winkel $\alpha_3$ größer als der Grenzwinkel der Totalreflexion beim Übergang Silizium/Luft von

$$\alpha_g = \arcsin(n_o/n_3) = 16,7°$$

ist, wird das Lichtbündel L2 unter dem Winkel

$$\gamma_{22} = \alpha_3 - \alpha = 6,3°$$

gegen die Flächennormale der Trägeroberfläche gebrochen. Der Winkel $\gamma_{22}$ ist kleiner als $\alpha_g$, so daß das Lichtbündel L2 auf der Oberfläche des Siliziumträgers T3 austreten kann. An der Austrittstelle des Lichtbündels L2 wird die Empfangsdiode PD montiert. Die Position für die Photodiode ergibt sich aus den oben genannten Winkeln, dem Abstand der beiden Vertiefungen V31 und V32 voneinander und mit geringer Abhängigkeit von der Dicke des Trägers T3. Die Position der Lichtaustrittsfläche von L2 hängt dagegen nicht von der axialen Position der Faser Fa in der V-Nut V31 ab. Die Position der Lichtaustrittsfläche kann daher relativ zu den mikromechanisch erzeugten Vertiefungen V31 und V32 durch Marken oder Anschläge gekennzeichnet werden. Diese Marken oder Anschläge können durch photolithographische Technik sehr genau zu den Vertiefungen V31 und V32 ausgerichtet werden. Durch laterale Verschiebung des Trägers T3 relativ zum Träger T2 ist eine laterale Justage der Faser Fa relativ zum Bildpunkt des Sendelichtbündels L1 möglich. Auch eine eventuell erforderliche axiale Justage der Faser durch Verschieben der Faser in der V-Nut V31 ist möglich, ohne daß die Position der Lichtaustrittsfläche des Empfangslichtbündels L2 dadurch geändert wird. Die Aufgabe, die Position der Photodiode zum Empfangslichtbündel unabhängig von der Justage der Faser zum Sendelichtbündel zu halten wird also durch die beschriebene erfindungsgemäße Anordnung erreicht. Dabei ist weiter sehr vorteilhaft, daß alle optoelektronischen Bauteile planar montiert werden können.

Ein weiterer Vorteil der erfindungsgemäßen Lösung liegt darin, daß hierbei eine sehr hohe nahe Übersprechdämpfung erreicht werden kann. Eine hohe nahe Übersprechdämpfung ist erforderlich, damit das Sendesignal aus dem Laser nicht infolge ungenügender Richtungstrennung in die in der Nähe des Senders befindliche Empfangsdiode trifft und diese beim Empfang schwacher Nutzsignale stört. Filterschichten haben im allgemeinen nur eine begrenzte Fähigkeit zur Trennung verschiedener Wellenlängen. Daher wird ein kleiner Anteil des Sendelichtbündels L1 die Filterschicht S31 auch durchdringen. Der Strahlverlauf dieses Störlichtes ist als S1' gestrichelt dargestellt. Dieses Lichtbündel trifft aber unter dem Winkel

$$\gamma_{13}' = \alpha - \beta_3 = 45{,}2°$$

gegen die Flächennormale auf die Oberfläche des Trägers T3 auf. Dieser Winkel ist aber größer als der Grenzwinkel der Totalreflexion $\alpha_g = 16{,}7°$, so daß das direkte Störlicht vom Sender nicht in die Empfangsdiode gelangen kann.

In einer Variante des ersten Ausführungsbeispiels wird das Filter Fi1 so ausgelegt, daß noch ein geringer Teil des Sendelichtes das Filter durchdringt, während der größte Teil reflektiert wird. Dieses das Filter durchdringende Lichtbündel L1' wird erfindungsgemäß als Regelsignal benutzt. Die Monitordiode MD' wird dann nicht auf dem Träger T1 sondern in einer Aussparung V33 auf dem Träger T2 montiert. Dies ist in der Fig. 1a gestrichelt dargestellt.

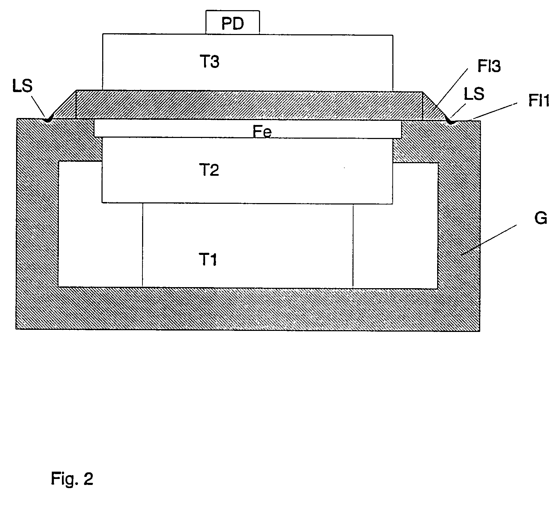

Zur lateralen aktiven Justage der Faser zum Sendelichtbündel L1 wird der Träger T3 zweckmäßigerweise in einem Metallflansch Fl3 eingesetzt, dessen Randfläche auf der als Flanschfläche Fl1 ausgebildeten Seitenwand Sw eines Gehäuses G aufliegt, in welchem die Träger T1 und T2 montiert sind. Nach Erreichen der optimalen Koppelposition werden die Flanschflächen Fl3 und Fl2 beispielsweise durch Laserschweißpunkte LS in ihrer Position zueinander fixiert. Der Träger T2 kann dabei als lichtdurchlässiger hermetisch dichter Deckel des Gehäuses G dienen. Ebenso kann auch ein zusätzliches hermetisch dichtes Fenster Fe zwischen den Trägern T2 und T3 eingesetzt werden. (Siehe Fig. 2).

In einem zweiten Ausführungsbeispiel der erfindungsgemäßen Lösung wird der Träger T3 nicht mit seiner Unterseite sondern mit seiner Stirnseite zum Träger T2 ausgerichtet.

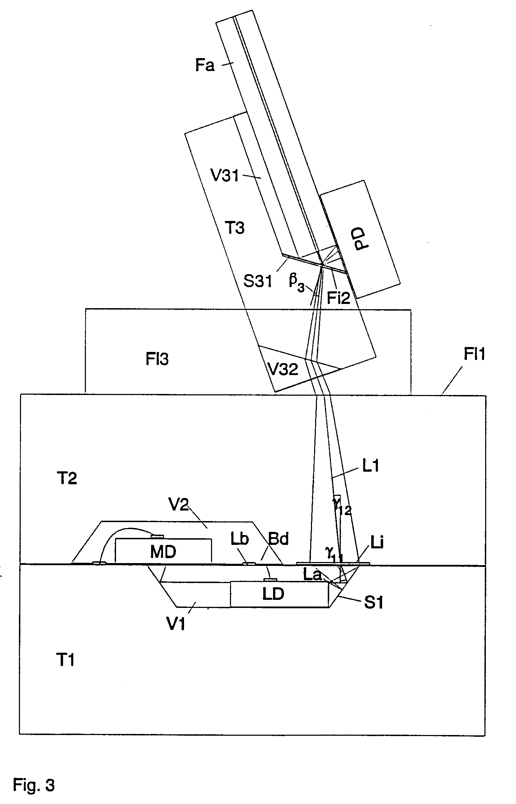

Das zweite erfindungsgemäße Ausführungsbeispiel ist in der Fig. 3 dargestellt. Die Träger T1 und T2 sind wie im ersten Ausführungsbeispiel aufgebaut. Die Faser Fa wird auch hier wieder in einer V-Nut V31 in einem Träger T3 geführt und ist auch in dieser V-Nut axial justierbar. Die Stirnseite S31 ist ebenfalls mit einer wellenlängenselektien Filterschicht Fi2 belegt. Im Unterschied zur Filterschicht F11 im ersten Ausführungsbeispiel ist die Filterschicht Fi2 für die Sendewellenlänge $\lambda_1$ durchlässig und für die Empfangswellenlänge $\lambda_2$ reflektierend. Das unter einem Winkel von $\gamma_{11} = 19{,}5°$ aus dem Träger T2 austretende Lichtbündel L1 trifft auf die Seitenwand S31 einer von der entgegengesetzten Seite in den Träger T3 anisotrop geätzten Vertiefung V32, deren der Seitenwand S32 gegenüberliegender Teil, beispielsweise durch Sägen, entfernt worden ist. Da die beiden Seitenflächen S32 und S31 parallel zueinander sind, wird das Sendelichtbündel S1 durch die zweimalige Brechung parallel versetzt und trifft dann in die Übertragungfaser Fa. Der Träger T3 muß dabei unter dem Winkel $\gamma_{11} = 19{,}5°$ gegenüber der Flächennormalen des Trägers T2 geneigt sein. Hierzu wird er unter diesem Winkel in den Flansch F3 geneigt eingebaut.

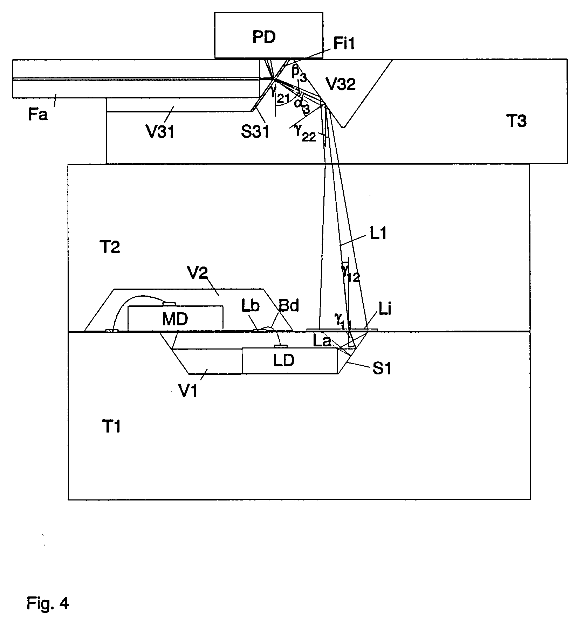

Ein drittes Ausführungsbeispiel der erfindungsgemäßen Lösung ist in der Fig. 4 dargestellt. Hier ist der Träger T3 ähnlich wie im ersten Ausführungsbeispiel aufgebaut aber gegenüber dem ersten Ausführungsbeispiel vertikal und horizontal gespiegelt. Die Filterschicht Fi2 muß wie im Ausführungsbeispiel 2 für die Sendewellenlänge transparent und für die Empfangswellenlänge reflektierend sein. Die Photodiode PD für das Empfangssignal wird wie beim Ausführungsbeispiel 2 im Bereich über der Stirnfläche der V-Nut V31 montiert. Wie im Ausführungsbeispiel 2 hat man auch hier den Vorteil, daß der Weg zwischen Faserstirnfläche und Photodiode sehr kurz ist, was eine geringe Strahlaufweitung zur Folge hat und daher eine sehr kleinflächige Photodiode, die für hohe Frequenzen geeignet ist, erlaubt. Der Richtungswinkel $\gamma_{12}$ des Strahlbündel im Träger T2 ist für das Trägermaterial Silizium 5,5° und der Richtungswinkel $\gamma_{22}$ des Strahlbündels im Träger T3 6,3°. Der Winkelunterschied von 0,8° ergibt einen Koppelverlust von ca. 0,1 dB und ist in den meisten Anwendungen tolerierbar. Der Winkel $\gamma_{12}$ läßt sich aber durch die Lage des Linsenmittelpunktes der Linse Li relativ zur Fläche S1 korrigieren. Der gegenüber dem ersten Ausführungsbeispiel hier längere Lichtweg im Träger T3 für das Sendelichtbündel muß durch eine entsprechende Dicke des Trägers T2 kompensiert werden.

Ein sehr wichtiger Gesichtspunkt bezüglich der Kosten beim Einsatz von Laserdioden in Sendemodulen bzw. Sende- und Empfangsmodulen liegt darin, daß die Laserdioden so früh wie möglich während des Herstellungsprozesses geprüft werden können. Während elektrische Prüfungen schon vor dem Vereinzeln durchgeführt werden können, können optische Prüfungen oft erst nach der Montage auf einzelnen Subsenken oder gar erst am fertigen Modul durchgeführt werden. Beim erfindungsgemäßen Montageverfahren können die Laserdioden in einem sehr frühen Stadium und im Großnutzen auf ihre optischen Funktionen geprüft werden. Dazu werden die Laserdioden in die Vertiefungen V1 eines im Großnutzen hergestellten Trägersubstrates T1 montiert bevor dieses Trägersubstrat in einzelne Träger vereinzelt wird. Auf diese Weise können die Optischen Eigenschaften für eine große Anzahl von Laserdioden gemeinsam geprüft werden. Der Träger T2 mit den Linse Li wird ebenfalls im Großnutzen für viele Einzel-Module hergestellt und alle Linsen gemeinsam zu den Lasern in einem einzigen Justage- und Montageprozeß montiert. Hier ist eine passive Justage mittels Marken oder eine justagefreie Montage durch mikromechanisch strukturierte Anschläge möglich. Die Vertiefungen V2 im Träger T2 sind dabei so gestaltet, daß die optoelektonischen und elektronischen Bauelemente wie die Laserdiode LD, die Monitordiode MD oder hier nicht dargestellt elektronische Bausteine zur Ansteuerung des Lasers hermetisch dicht eingeschlossen sind. Nach der gemeinsamen Verbindung der Trägersubstrate T1 und T2 diese durch Sägen oder durch Brechen an mikromechanisch erzeugten Sollbruchlinien vereinzelt. Die Lage der Säge- bzw. Bruchlinien liegt dabei so, daß die Position der Vertiefungen V1 und V2 sowie der Linsen Li nicht berührt werden.

Die Monitordiode MD kann auch auf der Unterseite oder Oberseite der Träger T2 oder T3 montiert werden, wobei in dem jeweils benachbarten Träger entsprechende Aussparungen vorzusehen sind. Zur Ankopplung der Monitordiode kann auf dem Träger T2 eine weitere Linse Lim vorgesehen werden.

**Patentansprüche**

1. Optische Sende- und Empfangseinrichtung mit einem Sendeelement (LD), das auf einem ersten Träger (T1) fixiert ist, mit einem Empfangselement (PD) und einer Übertragungsfaser (Fs), die auf einem dritten Träger (T3) fixiert sind und mit einem zweiten Träger (T2), der sich zwischen dem ersten und dem dritten Träger (T1, T3) befindet, mit V-Nuten und Vertiefungen in den Trägern (T1, T2, T3), die durch anisotropes Ätzen hergestellt sind, mit mindestens einer Spiegelfläche an jedem der äußeren Träger (T1, T3), dadurch gekennzeichnet, daß der dritte Träger (T3) für Licht mit der Wellenlänge des vom Sendeelement (LD) ausgesendeten Lichtes transparent ist, daß eine Monitordiode (MD) vorgesehen ist, die auf der Oberfläche des ersten Trägers (T1) in einer Aussparung des zweiten Trägers (T2) montiert ist.

2. Optische Sende- und Empfangseinrichtung mit einem Sendeelement (LD), das auf einem ersten Träger (T1) fixiert ist, mit einem Empfangselement (PD) und einer Übertragungsfaser (Fs), die auf einem dritten Träger (T3) fixiert sind und mit einem zweiten Träger (T2), der sich zwischen dem ersten und dem dritten Träger (T1, T3) befindet, mit V-Nuten und Vertiefungen in den Trägern (T1, T2, T3), die durch anisotropes Ätzen hergestellt sind, mit mindestens einer Spiegelfläche an jedem der äußeren Träger (T1, T3), dadurch gekennzeichnet, daß der dritte Träger (T3) für Licht mit der Wellenlänge des vom Sendeelement (LD) ausgesendeten Lichtes transparent ist, daß eine Monitordiode (MD) vorgesehen ist, die auf der Oberfläche des zweiten Trägers (T2) in einer Aussparung des dritten Trägers (T3) montiert ist.

3. Optische Sende- und Empfangseinrichtung nach Anspruch 1, dadurch gekennzeichnet, daß die optische Achse der Übertragungsfaser (Fa) einen Winkel im Bereich zwischen 50° und 90° mit der Oberfläche der Träger (T1, T2) einschließt.

Fig. 1

Fig. 1a

Fig. 2

Fig. 3

Fig. 4

Europäisches
Patentamt

**EUROPÄISCHER RECHERCHENBERICHT**

Nummer der Anmeldung

EP 95 11 6409

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A,D | DE-C-39 14 835 (ANT NACHRICHTENTECHNIK GMBH) 26.Juli 1990 * das ganze Dokument * --- | 1,2 | G02B6/42 G02B6/43 |
| A | EP-A-0 366 974 (TELEFUNKEN SYSTEMTECHNIK) 9.Mai 1990 * das ganze Dokument * --- | 1,2 | |
| A | DE-A-43 13 487 (ANT NACHRICHTENTECH) 26.Mai 1994 * das ganze Dokument * --- | 1,2 | |
| A | PATENT ABSTRACTS OF JAPAN vol. 008 no. 248 (P-313) ,14.November 1984 & JP-A-59 121008 (TOUKIYOU KOGYO DAIGAKU) 12.Juli 1984, * Zusammenfassung * --- | 1,2 | |
| A | WO-A-93 21551 (DEUTSCHE AEROSPACE ;HEINEMANN STEFAN (DE); MEHNERT AXEL (DE); PEUS) 28.Oktober 1993 * Seite 1, Zeile 4 - Zeile 16 * * Seite 3, Zeile 18 - Zeile 32 * * Seite 4 - Seite 6 * * Abbildungen 2-4 * --- | 1,2 | **RECHERCHIERTE SACHGEBIETE (Int.Cl.6)** G02B |
| A | DE-A-43 13 493 (ANT NACHRICHTENTECH) 26.Mai 1994 * das ganze Dokument * ----- | 1,2 | |

Der vorliegende Recherchenbericht wurde für alle Patentansprüche erstellt

| Recherchenort | Abschlußdatum der Recherche | Prüfer |
|---|---|---|
| DEN HAAG | 15.März 1996 | Mathyssek, K |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
........................................................................................
& : Mitglied der gleichen Patentfamilie, übereinstimmendes
    Dokument

EPO FORM 1503 03.82 (P04C03)